Europäisches Patentamt

(19) European Patent Office

Office européen des brevets

(11) Numéro de publication: **0 184 877**
**B1**

(12) **FASCICULE DE BREVET EUROPEEN**

(45) Date de publication du fascicule du brevet: **31.10.90**

(51) Int. Cl.⁵: **G 09 F 9/33, H 01 L 33/00**

(21) Numéro de dépôt: **85201902.5**

(22) Date de dépôt: **19.11.85**

(54) Matrice d'éléments électro-luminescents et son procédé de fabrication.

(30) Priorité: **07.12.84 FR 8418731**

(43) Date de publication de la demande:
**18.06.86 Bulletin 86/25**

(45) Mention de la délivrance du brevet:
**31.10.90 Bulletin 90/44**

(84) Etats contractants désignés:
**DE FR GB NL**

(56) Documents cités:
**EP-A-0 127 239**
**FR-A-1 490 665**
**FR-A-1 574 172**
**US-A-3 512 027**
**US-A-4 336 580**

**22nd ELECTRONICS COMPONENTS
CONFERENCE, 15-17 mai 1972, pages 148-157;
S.J. STEIN: "Thick film materials for electrooptical applications"**

(73) Titulaire: **PHILIPS COMPOSANTS
117, quai du Président Roosevelt
F-92130 Issy les Moulineaux (FR)**
(84) **FR**

(73) Titulaire: **N.V. Philips' Gloeilampenfabrieken
Groenewoudseweg 1
NL-5621 BA Eindhoven (NL)**
(84) **DE GB NL**

(72) Inventeur: **Thillays, Jacques
SOCIETE CIVILE S.P.I.D. 209 rue de l'Université
F-75007 Paris (FR)**
Inventeur: **Talpied, André
SOCIETE CIVILE S.P.I.D. 209 rue de l'Université
F-75007 Paris (FR)**

(74) Mandataire: **Jacquard, Philippe et al
Société Civile S.P.I.D. 156, Boulevard
Haussmann
F-75008 Paris (FR)**

Courier Press, Leamington Spa, England.

EP 0 184 877 B1

## Description

La présente invention a pour objet une matrice d'éléments électro-luminescents montés sur un substrat isolant présentant des trajets conducteurs pour leur interconnexion électrique et disposés chacun au foyer d'un élément optique de collimation, au moins plusieurs desdits éléments étant ménagés dans au moins une plaque dont la face inférieure recouvre la face supérieure du substrat, et comportant pour chaque élément électro-luminescent, un élément optique de collimation et se prolongeant à travers des ouvertures cylindriques débouchant à la face inférieure de la plaque.

Une telle matrice est connue du brevet US 4 254 453 (MOUYARD et al.) déposé par la Société General Instrument Corporation, dans lequel les éléments électro-luminescents sont des diodes sous boîtier d'un type classique, et présentant des éléments de collimation constitués par des cavités paraboliques réfléchissantes. Les diodes sont maintenues mécaniquement par une plaque d'insertion commune à tous les éléments. Une carte de circuit imprimé simple ou double face est utilisée pour réaliser les connexions électriques. Le substrat est ainsi constitué par la plaque d'insertion et par la carte de circuit imprimé.

Cette matrice présente l'inconvénient d'un nombre élevé d'éléments et d'un montage relativement compliqué, car nécessitant des opérations d'alignement précis du circuit imprimé et de la plaque formant substrat, d'orientation préalable de l'anode et de la cathode des éléments électro-luminescents et d'insertion de celles-ci, chacune dans deux trous alignés d'un support 16 formant substrat et du circuit imprimé, de telle sorte que leurs sorties électriques s'écartent vers l'extérieur, de soudure des sorties électriques des diodes sur le circuit imprimé, et de mise en place de la plaque portant les cavités paraboliques de telle manière que les diodes soient maintenues en butée sur celle-ci grâce à l'élasticité de leurs sorties électriques écartées vers l'extérieur.

Selon l'invention, la matrice est plus simple que celle de l'art antérieur précité, car elle ne présente ni plaque spéciale formant circuit imprimé, ni panneau pour maintenir élastiquement la plaque portant les éléments optiques de collimation. De fait, selon l'invention, la face inférieure de la plaque portant les éléments optiques de collimation est en contact direct avec le substrat constitué par une seule pièce qui présente des trajets conducteurs et sur lequel les éléments électro-luminescents sont montés directement.

Dans ce but, la matrice selon l'invention est caractérisée en ce que chaque élément comporte d'une part un support constitué d'une tige électriquement conductrice présentant une face supérieure et une face inférieure, d'une rondelle isolante entourant une partie latérale supérieure de la tige conductrice, et d'une rondelle conductrice entourant la rondelle isolante, et d'autre part un composant électro-luminescent monté à la face supérieure de la tige conductrice de manière à former un contact électrique avec celle-ci, en ce que la tige conductrice traverse un trou du substrat, le substrat étant d'une seule pièce et présentant des trajets conducteurs sur ses faces supérieure et inférieure de telle sorte que la face inférieure de la tige conductrice se trouve en contact électrique avec les trajets conducteurs de la face inférieure du substrat, en ce que la rondelle conductrice est raccordée électriquement d'une part au composant électro-luminescent et d'autre part aux trajets conducteurs de la face supérieure du substrat, et en ce qu'au moins la face inférieure et les ouvertures cylindriques de la plaque sont isolantes, lesdites ouvertures cylindriques s'engageant à faible jeu dans les rondelles conductrices.

De la sorte, le substrat porte directement sur ses deux faces les trajets conducteurs qui ont également pour fonction de maintenir en place les éléments électro-luminescents, et la plaque portant les éléments optiques de collimation vient en contact avec le substrat et est maintenue en place par coopération à faible jeu entre les ouvertures cylindriques prolongeant les éléments optiques de collimation et les rondelles conductrices correspondantes.

On connaît de l'antériorité FR 1 574 172 une matrice d'éléments électro-luminescents présentant des tiges formant des passages conducteurs, mais elle est conçue Pour être montée sur une pièce conductrice (traversées isolantes en verre par soudure verre-métal) et ne présente ni trajets conducteurs, ni élément de collimation.

Les éléments optiques de collimation du dispositif selon l'invention peuvent être choisis parmi les cavités paraboliques réfléchissantes telles que celles décrites dans le brevet US 4 254 453 précité, ou bien les conduits de lumière du type de ceux décrits par exemple dans la demande de brevet DE-A 2 201 574 (SIEMENS AG), ou dans la demande EP 117 606 (XEROX Corp.).

Selon un mode de réalisation préféré, les trajets conducteurs d'au moins une face du substrat sont sérigraphiés. Il est alors avantageux que la face inférieure des tiges conductrices dépasse légèrement du trou correspondant du substrat. Le raccordement électrique des éléments de la matrice est en général tel que les trajets conducteurs du substrat connectent les éléments électro-luminescents selon des lignes sur une face du substrat et selon des colonnes sur l'autre face de celui-ci.

Les composants électro-luminescents peuvent être enrobés dans un dôme de protection en matériau transparent adaptant les indices optiques entre lesdits composants et l'air.

Le substrat peut être avantageusement en matériau bon conducteur thermique, par exemple de l'aluminium revêtu d'une couche d'oxydation anodique. Les calories dissipées par les diodes étant véhiculées vers le substrat principalement par l'intermédiaire des tiges conductrices, on obtient une bonne évacuation thermique.

Le procédé selon l'invention est également plus facile à mettre en oeuvre que celui de l'art antérieur précité. On remarquera en particulier que l'assemblage selon l'antériorité US 4 254 453 est peu pratique, et que l'antériorité FR 1 574 172 impose de réaliser des soudures verre-métal des tiges conductrices et donc de souder les cristaux de diode in situ après cette opération.

L'étape d'insertion consiste simplement à introduire les tiges conductrices dans les trous correspondants du substrat sans qu'il soit besoin de les orienter angulairement et les éléments sont maintenus en place par solidarisation avec les trajets conducteurs du substrat. La mise en place de la plaque portant les éléments optiques de collimation est également simplifiée du fait que celle-ci est positionnée par la coopération à faible jeu entre les parties cylindriques de la plaque et les anneaux conducteurs, et par sa venue en butée sur le substrat. Les éléments opto-électroniques forment des sous-ensembles qui peuvent être réalisés au préalable.

Le procédé selon l'invention vise à fabriquer une matrice telle qu'elle a été définie ci-dessus et comporte à cet effet les étapes suivantes:

a) réaliser selon une géométrie désirée des trajets conducteurs au moins sur une face supérieure d'un substrat isolant pourvu de trous destinés à recevoir lesdits éléments.

b) insérer dans les trous au moins les supports des éléments, ceux-ci comportant une tige électriquement conductrice présentant une face supérieure et une face inférieure, une rondelle isolante entourant une partie latérale supérieure de la tige conductrice, et une rondelle conductrice entourant la rondelle isolante, la géométrie désirée des trajets conducteurs étant telle que ceux-ci viennent en contact électrique avec les anneaux conducteurs correspondants.

c) solidariser les anneaux conducteurs et les trajets conducteurs correspondants de la face supérieure du substrat.

d) réaliser selon une géométrie désirée des trajets conducteurs sur la face inférieure du substrat de telle manière que ceux-ci viennent en contact électrique avec la face inférieure de la tige conductrice.

e) solidariser la tige conductrice et les trajets conducteurs correspondants de la face inférieure du substrat.

f) disposer sur le substrat au moins une plaque présentant une pluralité d'éléments optiques de collimation, se prolongeant par des ouvertures cylindriques isolantes venant s'engager à faible jeu dans les rondelles conductrices, jusqu'à ce que la face inférieure isolante de la plaque vienne en butée sur le substrat.

Selon un mode de réalisation préféré, les trajets conducteurs d'au moins une face du substrat sont réalisés par sérigraphie, ladite solidarisation étant obtenue par cuisson des trajets sérigraphiés.

La structure de la matrice permet de monter les composants électro-luminescents sur la face supérieure des tiges conductrices soit avant l'insertion des supports dans les trous du substrat isolant, c'est-à-dire que l'on insère des éléments électro-luminescents complets, soit après ladite insertion des supports, c'est-à-dire que les éléments sont complétés collectivement sur la matrice elle-même après l'une quelconque des étapes c à f. Le composant électro-luminescent peut être enrobé d'un dôme de protection en matériau transparent faisant également fonction d'adaptateur d'indice.

l'invention sera mieux comprise à la lecture de la description qui va suivre, donnée à titre d'exemple non limitatif en liaison avec les figures qui représentent:

les figures 1a à 1c, respectivement un support avant montage, un support après montage, et un élément électro-luminescent pré-assemblé;

la figure 2, une vue de dessus d'une plaque portant les cavités paraboliques;

la figure 3a, une vue en coupe d'un substrat isolant selon l'invention, la figure 3b, un détail d'une métallisation de la face supérieure dudit substrat; et

la figure 4 un détail en coupe d'une matrice selon l'invention.

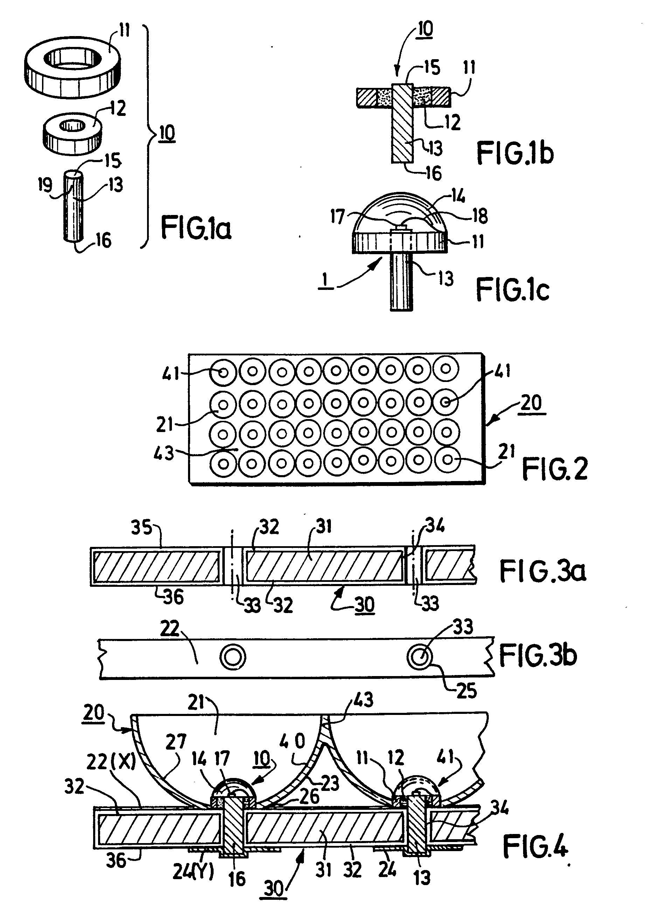

Selon la figure 1a, un support 10 est constitué d'une tige conductrice cylindrique 13, généralement en métal, présentant une face supérieure 15 et une face inférieure 16, d'une rondelle isolante 12, en verre ou en matériau thermoplastique dont le diamètre intérieur correspond à celui de la tige et d'une rondelle conductrice 11 dont le diamètre intérieur correspond au diamètre extérieur de la rondelle isolante 12.

Selon la figure 1b, le montage de ces trois éléments est réalisé de telle sorte que la rondelle 12 est montée sur la partie latérale supérieure 19 de la tige 13 et que les rondelles 11 et 12 soient situées dans le même plan et que la face supérieure 15 de la tige conductrice 13 dépasse légèrement. La solidarisation de la tige et des deux rondelles est aisée, soit par soudure verre-métal lorsque la rondelle 12 est en verre, soit par simple chauffage au cas où elle est en matériau thermoplastique.

Selon la figure 1c, un composant électro-luminescent 17 par exemple une diode est collé par une colle conductrice sur la face supérieure 15 de la tige conductrice 13. Le couplage optique peut être amélioré grâce à un dôme en résine transparente 14 permettant une adaptation d'indice entre le composant 17 et l'air. Ce dôme 14 recouvre également les anneaux 12 et 11 ce qui améliore la tenue mécanique du support 10. L'anode de la diode 17 est reliée électriquement à l'anneau conducteur 11 par un fil soudé 18.

Selon les figures 2 à 4, la matrice comporte un substrat isolant 30 présentant des trous 21 disposés selon des lignes et des colonnes pour former le réseau de la matrice. Le substrat 30 est ici en aluminium 31 recouvert d'une couche d'anodisation recouvrant en 32 ses faces supérieure 35 et inférieure 36 et en 34 les bords des trous 33.

Dans la matrice terminée (fig. 4), les tiges conductrices 13 sont disposées à faible jeu dans les trous 33, et les rondelles 11 et 12 viennent en butée sur des métallisations 22 (axe X) situées sur la face supérieure 35 du substrat 30. Les faces inférieures 16 des tiges 13 viennent en contact avec des métallisations 24 de la face inférieure 36 du substrat 30. Les métallisations 22, de préférence obtenues par sérigraphie, sont disposées selon des lignes et les métallisations 24 (axe Y), de préférence obtenues par sérigraphie, selon des colonnes de manière à obtenir l'interconnexion classique dans les matrices. La partie inférieur 16 des tiges 13 dépasse avantageusement de la face inférieure 36 du substrat 30 et est recouverte par la métallisation sérigraphiée 24 ce qui en améliore la liaison mécanique et électrique. L'axe des métallisations 22 croise celui des trous 33 correspondant. Au niveau de ceux-ci, les métallisations 22 s'interrompent sur un cercle 25 de diamètre approximativement égal au diamètre intérieur des anneaux 11.

Une plaque 20 présente des cavités paraboliques 21 se prolongeant vers la face inférieure 23 de ladite plaque par des ouvertures circulaires 41 dont le diamètre extérieur correspond à un faible jeu près au diamètre extérieur des anneaux conducteurs 11. Les ouvertures 41 sont disposées selon le même réseau que les éléments 1. La plaque 20 est disposée de manière à venir en butée sur la face supérieure 35 du substrat 30. Plus particulièrement, chaque cavité 21 est constituée par une demi-coquille 40 à parois relativement minces, les coquilles étant solidaires les unes des autres à leur périphérie dans les régions 43. La face inférieure 23 des demi-coquilles 40 présente une région centrale 26 entourant les ouvertures 41 et qui vient en butée sur la face supérieure 35 du substrat 30.

Ladite plaque 20 peut être en matière plastique moulée et métallisée sur la face intérieure 27 des demicoquilles.

En tout état de cause, les régions centrales 26 et les ouvertures 41 se doivent de rester isolantes.

A titre de variante, la plaque 20 comporte au moins un conduit de lumière tel que décrit dans les demandes DE A 2 201 574 ou EP A 117 606 précitées. Un tel conduit, présente une cavité hémisphérique qu'il suffit de prolonger par une partie cylindrique coopérant à faible jeu avec l'anneau conducteur 11 correspondant.

Le montage de la matrice est réalisé de la manière suivante:

Les supports 10, sur lesquels ont été ou non montés les composants 17 sont introduits dans les trous 33 du substrat 30. Ensuite, on solidarise les métallisations 22 et les anneaux conducteurs 11. Si les métallisations 22 sont sérigraphiées, il suffit de réaliser la cuisson des trajets sérigraphiés. Pour des métallisations du type circuit imprimé, il suffit de réaliser des soudures sur un poste automatique.

On réalise alors les métallisations 24 sur la face inférieure 36 du substrat 30. Il est préférable de réaliser cette opération en retournant le substrat 30. La solution préférée est la sérigraphie, ce qui permet, par une étape ultérieure de cuisson de terminer la mise en place électrique et mécanique des supports. Il est avantageux de laisser dépasser la face inférieure 16 des tiges 13 de la face inférieure 36 du substrat 30.

La mise en place éventuelle de composants 17 et l'enrobage éventuel dans des dômes 14 peuvent être effectué à tout moment, mais elle interviendra avantageusement après les étapes de cuisson des sérigraphies.

Le montage de la matrice se termine par la pose de la ou des plaques 20 portant les cavités paraboliques 21. On remarquera que la forme de demi-coquilles 40 à parois minces de celles-ci, qui, du fait de la légère élasticité qu'elle présente, facilite dans une certaine mesure l'introduction des ouvertures 41 dans les anneaux 11.

L'invention ne se limite pas aux modes de réalisation décrits et représentés. Ainsi, des connexions en série entre des diodes de la matrice peuvent être obtenues au moyen de liaisons convenables vers un connecteur dans lequel le ' substrat est enfiché ou bien encore à l'aide d'au moins une pièce entièrement conductrice et de même forme que les supports 10 et disposée dans un trou 33 choisi de manière appropriée.

## Revendications

1. Matrice d'éléments électro-luminescents montés sur un substrat isolant présentant des trajets conducteurs pour leur interconnexion électrique et disposés chacun au foyer d'un élément optique de collimation, au moins plusieurs desdits éléments étant ménagés à la face supérieure d'au moins une plaque dont la face inférieure recouvre la face supérieure du substrat, et comportant pour chaque élément électro-luminescent un élément optique de collimation, et se prolongeant à travers des ouvertures cylindriques débouchant à la face inférieure de la plaque, caractérisée en ce que chaque élément (1) comporte d'une part un support (10) constitué d'une tige électriquement conductrice (13) présentant une face supérieure (15) et une face inférieure (16), d'une rondelle isolante (12) entourant une partie latérale supérieure (19) de la tige conductrice (13) et d'une rondelle conductrice (11) entourant la rondelle isolante (12) et d'autre part un composant électro-luminescent (17) monté à la face supérieure (15) de la tige conductrice (13) de manière à former un contact électrique avec celle-ci, en ce que la tige conductrice (13) traverse un trou (33) du substrat (30), le substrat (30) étant d'une seule pièce et présentant des trajets conducteurs (24, 22) sur ses faces supérieure (35) et inférieure (36), de telle sorte que la face inférieure (16) de la tige conductrice (13) se trouve en contact électrique avec des trajets conducteurs (24) de la face inférieure (36) du substrat (30), en ce que la rondelle conductrice (11) est raccordée électriquement d'une part au composant électro-luminescent (17) et d'autre part à des trajets conducteurs (22) de la face supérieure (35) du substrat (30) et en ce qu'au moins la face inférieure (26) et les ouvertures cylindriques (41) de la plaque (20) sont isolantes, lesdites ouvertures cylindriques (41) s'engageant à faible jeu dans les rondelles conductrices (11).

2. Matrice selon la revendication 1, caractérisée en ce qu'au moins un élément optique de collimation est constitué par une cavité parabolique réfléchissante (21) à parois minces (27).

3. Matrice selon l'une des revendications 1 ou 2, caractérisée en ce que les trajets conducteurs (22, 24) d'au moins une face (35, 36) du substrat (30) sont sérigraphiés.

4. Matrice selon l'une des revendications 1 à 3, caractérisée en ce que la face inférieure (16) de la tige conductrice (13) dépasse légèrement du trou correspondant (33) du substrat (30).

5. Matrice selon l'une des revendications précédentes, caractérisée en ce que les trajets conducteurs (22, 24) du substrat sont agencés pour raccorder électriquement les éléments électroluminescents selon des lignes sur une face (35) du substrat (30) et selon des colonnes sur l'autre face (36) de celui-ci.

6. Matrice selon l'une des revendications précédentes, caractérisée en ce qu'au moins un composant électro-luminescent (17) est enrobé dans un dôme de protection (14) en matériau transparent adaptant les indices optiques desdits composants (17) et l'air.

7. Matrice selon l'une des revendications précédentes, caractérisée en ce que le substrat (30) est constitué d'un matériau bon conducteur thermique.

8. Matrice selon la revendication 7, caractérisée en ce que ledit matériau est de l'aluminium (31) revêtu d'une couche d'oxydation anodique (32).

9. Matrice selon l'une des revendications 7 ou 8, caractérisée en ce qu'elle comporte au moins une pièce conductrice de même forme que les supports (10) disposée dans un trou (33) du substrat (30) et réalisant des connexions en série de certaines au moins des diodes de la matrice.

10. Procédé de fabrication d'une matrice d'éléments électro-luminescents, chaque élément électro-luminescent étant constitué d'un sous-ensemble présentant d'une part un support (10) constitué d'une tige électriquement conductrice (13) présentant une face supérieure (15) et une face inférieure (16), d'une rondelle isolante (12) entourant une partie latérale supérieure (12) de la tige conductrice (13) et d'une rondelle conductrice (11) entourant la rondelle isolante (12) et d'autre part un composant électro-luminescent (17) monté à la face supérieure (15) de la tige conductrice (13) de manière à former un contact électrique avec celle-ci, selon l'une des revendications précédentes, caractérisé en ce qu'il comporte les étapes suivantes:

a) réaliser selon une géométrie désirée des trajets conducteurs (22) sur une face supérieure (35) d'un substrat isolant (30) pourvu de trous destinés (33) à recevoir lesdits éléments (1),

b) insérer dans les trous (33) au moins les supports (10) des éléments (1) ceux-ci comportant une tige (13) électriquement conductrice présentant une face supérieure (15) et une face inférieure (16), une rondelle isolante (12) entourant une partie latérale supérieure (19) de la tige conductrice (13), et une rondelle conductrice (11) entourant la rondelle isolante (12), la géométrie désirée des trajets conducteurs (22) étant telle que ceux-ci viennent en contact électrique avec les rondelles conductrices (11) correspondants,

c) solidariser les rondelles conductrices (11) et les trajets conducteurs correspondants (22) de la face supérieure (35) du substrat (30),

d) réaliser selon une géométrie désirée des trajets conducteurs (24) sur la face inférieure (36) du substrat (30) de telle manière que ceux-ci viennent en contact électrique avec la face inférieure (36) de la tige conductrice (13),

e) solidariser la tige conductrice (13) et les trajets conducteurs correspondants (24) de la face inférieure (36) du substrat (30),

f) disposer sur le substrat au moins une plaque (20) présentant une pluralité de cavités paraboliques réfléchissantes (21) se prolongeant par des ouvertures cylindriques isolantes (41) venant s'engager à faible jeu dans les rondelles conductrices (11) jusqu'à ce que la face inférieure isolante de la plaque vienne en butée sur le substrat (30).

11. Procédé selon la revendication 10, caractérisé en ce que les trajets conducteurs (22, 24) d'au moins une des faces (35, 36) du substrat (30) sont réalisés par sérigraphie ladite solidarisation étant obtenue par cuisson des trajets sérigraphiés (22, 24).

12. Procédé selon l'une des revendications 10 ou 11, caractérisé en ce que des composants électro-luminescents (17) sont montés sur la face supérieure (15) des tiges conductrices (13) avant l'insertion des supports (10) dans les trous (33) du substrat isolant (30).

13. Procédé selon l'une des revendications 10 ou 11, caractérisé en ce que des composants électro-luminescents (17) sont montés sur la face supérieure (15) des tiges conductrices (18) après l'une quelconque des étapes a) à f).

14. Procédé selon l'une des revendications 12 ou 13, caractérisé en ce qu'il comporte une étape pour enrober les composants électro-luminescents (17) d'un dôme de protection (14) en matériau transparent.

**Patentansprüche**

1. Matrix von Leuchtelementen, die auf einem isolierenden Träger mit Leiterspuren zur elektrischen Verbindung derselben angeordnet sind, und die je im Brennpunkt eines optischen Kollimationselementes vorgesehen sind, wobei wenigstens einige der genannten Elemente auf der oberen Fläche wenigstens einer Platte angeordnet sind, deren untere Fläche die obere Fläche des Trägers bedeckt, wobei für jedes Leuchtelement ein optisches Kollimationselement vorhanden ist, und wobei sich durch dieselbe zylinderförmige Öffnungen hindurch erstrecken, die an der unteren Fläche der Platte münden, dadurch gekennzeichnet, daß jedes Element (1) einerseits einen Trägerteil (10) aufweist, der durch einen elektrisch leitenden Stift (13) mit einer oberen Fläche (15) und einer unteren Fläche (16), durch einen einen oberen Mantelteil (19) des leitenden Stiftes (13) umgebenden isolierenden Ring (12), sowie durch einen den isolierenden Ring (12) umgebenden leitenden Ring (11) gebildet ist, und andererseits einen Leuchtteil (17) aufweist, der derart auf der oberen Fläche (15) des leitenden Stiftes (13) angeordnet ist, daß damit ein elektrischer Kontakt gebildet wird, daß der leitende Stift (13) sich durch eine Öffnung (33) in dem Träger (30) hindurch erstreckt, wobei der Träger (30) aus nur einem Teil besteht und auf der oberen (35) sowie unteren Fläche (36) Leiterspuren (24, 22) aufweist, derart, daß die untere Fläche (16) des leitenden Stiftes (13) die Leiterspuren (24) der unteren Fläche (36) des Trägers (30) kontaktiert, daß der leitende Ring (11) einerseits mit dem Leuchtteil (17) in elektrischem Kontakt steht und andererseits mit Leiterspuren (22) der oberen Fläche (35) des Trägers (30), und daß wenigstens die untere Fläche (26) und die zylinderförmigen Öffnungen (41) der Platte (20) isolierend sind, wobei die genannten zylinderförmigen Öffnungen (41) mit gewissem Spielraum mit den leitenden Ringen (11) zusammenarbeiten.

2. Matrix nach Anspruch 1, dadurch gekennzeichnet, daß wenigstens ein optisches Kollimationselement durch einen reflektierenden parabelförmigen Hohlraum (21) mit dünnen Wänden (27) gebildet wird.

3. Matrix nach einem der Ansprüche 1 oder 2, dadurch gekennzichnet, daß die Leiterspuren (22, 24) wenigstens einer Fläche (35, 36) des Trägers (30) im Siebdruckverfahren hergestellt worden sind.

4. Matrix nach einem der Ansprüche 1 bis 3, dadurch gekennzeichnet, daß die untere Fläche (16) des leitenden Stiftes (13) auf einfache Weise durch die entsprechende Öffnung (33) in dem Träger (30) hindurchgeht.

5. Matrix nach einem der vorstehenden Ansprüche. dadurch gennzeichnet, daß die Leiterspuren (22, 24) des Trägers dazu vorgesehen sind, die Leuchtelemente auf der Fläche (35) des Trägers (30) zeilenweise und auf der anderen Fläche (36) desselben spaltenweise elektrisch zu verbinden.

6. Matrix nach einem der vorstehenden Ansprüche, dadurch gekennzeichnet, daß wenigstens ein Leuchtteil (17) von einer aus transparentem Werkstoff bestehenden Schutzhaube (14) umgeben ist, wodurch die optischen Eigenschaften der genannten Teile (17) und von Luft aneinander angepasst werden.

7. Matrix nach einem der vorstehenden Ansprüche dadurch gekennzeichnet, daß der Träger (30) aus einem thermisch gut leitenden Werkstoff besteht.

8. Matrix nach Anspruch 7, dadurch gekennzeichnet, daß der genannte Werkstoff mit einer anodischen Oxidationsschicht (32) versehenes Aluminium (31) ist.

9. Matrix nach einem der Ansprüche 7 oder 8, dadurch gekennzeichnet, daß sie mindestens einen leitenden Teil derselben Form wie die der Trägerteile (10) aufweist, wobei dieser Teil in einer Öffnung (33) des Trägers (30) angeordnet ist und Reihenschaltungen aus mindestens bestimmten Dioden der Matrix bildet.

10. Verfahren zum Herstellen einer Matrix von Leuchtelementen, wobei jedes Leuchtelement aus einem Teilgefüge besteht, das einerseits einen aus einem elektrisch leitenden Stift (13) bestehenden Trägerteil (10) mit einer oberen Fläche (15) und einer unteren Fläche (16), einen einen oberen Mantelteil (12) des leitenden Stiftes (13) umgebenden isolierenden Ring (12) sowie einen den isolierenden Ring (12) umgebenden leitenden Ring (11), und andererseits einen auf der oberen Fläche (15) des leitenden Stiftes (13) angeordneten Leuchtteil (17) aufweist, derart, daß dieser Teil mit dem Stift einen elektrischen Kontakt macht, nach einem der vorstehenden Ansprüche, dadurch gekennzeichnet, daß das Verfahren die nachfolgenden Verfahrensschritte aufweist:

a) das Ausbilden entsprechend einem gewünschten geometrischem Muster der Leiterspuren (22) auf einer oberen Fläche (35) eines isolierenden Trägers (30) mit Öffnungen (33) zum Aufnehmen der genannten Elemente (1),

b) das Einführen wenigstens derjenigen Trägerteile (10) der Elemente (1), die einen elektrisch leitenden Stift (13) mit einer oberen Fläche (15) und einer unteren Fläche (16), einen einen oberen Mantelteil (19) des leitenden Stiftes (13) umgebenden isolierenden Ring (12) und einen den isolierenden Ring (12) umgebenden leitenden Ring (11) aufweisen, in die Öffnungen (33), wobei die gewünschte geometrische Form der Leiterspuren (22) derart ist, daß diese mit den entsprechenden leitenden Ringen (11) elektrisch kontaktiert werden,

c) das Zusammenfügen der leitenden Ringe (11) und der entsprechenden Leiterspuren (22) der oberen Fläche (35) des Trägers (30),

d) das Ausbilden entsprechend einer gewünschten geometrischen Form von Leiterspuren (24) auf der unteren Fläche (36) des Trägers (30), derart, daß diese mit der unteren Fläche (36) des leitenden Stiftes (13) elektrisch kontaktiert werden,

e) das Zusammenfügen des leitenden Stiftes (13) und der entsprechenden Leiterspuren (24) auf der unteren Fläche (36) des Trägers (30),

f) das Anbringen mindestens einer Platte (20) mit einer Anzahl parabelförmiger, reflektierender Hohlräume (21), die sich durch zylinderförmige isolierende Öffnungen (41) fortsetzen, die mit gewissem Spielraum in den leitenden Ringen (11) zusammenarbeiten, bis die isolierende untere Fläche der Platte an dem Träger (30) anliegt.

11. Verfahren nach Anspruch 10, dadurch gekennzeichnet, daß die Leiterspuren (22, 24) wenigstens einer der Flächen (35, 36) des Trägers (30) im Siebdruckverfahren hergestellt worden sind, wobei die Zusammenfügung durch Einbrennen der Siebdruckspuren (22, 24) erhalten worden ist.

12. Verfahren nach einem der Ansprüche 10 oder 11, dadurch gekennzeichnet, daß vor dem Einführen der Trägerteile (10) in die Öffnungen (33) des isolierenden Trägers (30) Leuchtteile (17) auf der oberen Fläche (15) der leitenden Stifte (13) angeordnet werden.

13. Verfahren nach einem der Ansprüche 10 oder 11, dadurch gekennzeichnet, daß Leuchtteile (17) erst nach jedem der Verfahrensschritte a) bis f) auf der oberen Fläche (15) der leitenden Stifte (13) angeordnet werden.

14. Verfahren nach einem der Ansprüche 12 oder 13, dadurch gekennzeichnet, daß das Verfahren einen Verfahrensschritt aufweist zum Einhüllen der Leuchtteile (17) mit einer Schutzhaube (14) aus transparentem Werkstoff.

**Claims**

1. A matrix of light-emitting elements mounted on an insulating substrate having conductor tracks for electrically interconnecting them and each arranged in the focus of an optical collimation element, at least several of said elements being provided on the upper surface of at least one wafer, whose lower surface covers the upper surface of the substrate, and comprising an optical collimation element for each light-emitting element and being prolonged by cylindrical openings merging at the lower surface of the wafer, characterized in that each element (1) comprises on the one hand a support (10) constituted by an electrically conducting pin (13) having an upper surface (15) and a lower surface (16), by an insulating ring (12) surrounding a lateral upper part (19) of the conducting pin (13) and by a conducting ring (11) surrounding the insulating ring (12) and on the other hand a light-emitting component (17) mounted on the upper surface (15) of the conducting pin (13) in such a manner that it forms an electrical contact with the latter, in that the conducting pin (13) traverses a hole (33) of the substrate (30) the substrate (30) being a single piece and having conductor tracks (24, 22) on its upper (35) and lower (36) surfaces in such a manner that the lower surface of the conducting pin (13) is in electrical contact with conductor tracks (24) of the lower surface (36) of the substrate (30), in that the conducting ring (11) is electrically connected on the one hand to the light-emitting component (17) and on the other hand to conductor tracks (22) of the upper surface (35) of the substrate (30), and in that at least the lower surface (26) and the cylindrical openings (41) of the wafer (20) are insulating, said cylindrical openings (41) engaging each other with a small amount of clearance in the conducting rings (11).

2. A matrix as claimed in Claim 1, characterized in that at least one optical collimation element is constituted by a parabolic reflecting cavity (21) having thin walls (27).

3. A matrix as claimed in any one of Claim 1 or 2, characterized in that the conductor tracks (22, 24) of at least one surface (35, 36) of the substrate (30) are obtained by silk screen printing.

4. A matrix as claimed in any one of Claims 1 to 3, characterized in that the lower surface (16) of the conducting pin (13) slightly projects beyond the corresponding hole (33) of the substrate (30).

5. A matrix as claimed in any one of the preceding Claims, characterized in that the conductor tracks (22, 24) of the substrate are arranged so as to connect electrically the light-emitting elements according to rows on one surface (35) of the substrate (30) and according to columns on the other surface (36) of the latter.

6. A matrix as claimed in any one of the preceding Claims, characterized in that at least one light-emitting component (17) is enveloped by a protective dome (14) of transparent material adapting the optical indices of the said components (17) and of air.

7. A matrix as claimed in any one of the preceding Claims, characterized in that the substrate (30) is constituted by a thermally well conducting material.

8. A matrix as claimed in Claim 7, characterized in that the said material is aluminium (31) coated with an anodic oxidation layer (32).

9. A matrix as claimed in any one of Claim 7 or 8, characterized in that it comprises at least one conducting part having the same shape as the supports (10) arranged in a hole (33) of the substrate (30) and forming series connections of at least a given number of the diodes of the matrix.

10. A method of manufacturing a matrix of light-emitting elements each light-emitting element being constituted by a sub-assembly comprising on the one hand a support (10) constituted by an electrically conducting pin (13) having an upper surface (15) and a lower surface (16), by an insulating ring (12) surrounding a lateral upper part (19) of the conducting pin (13) and by a conducting ring (11) surrounding the insulating ring (12) and on the other hand a light-emitting component (17) mounted on the upper surface (15) of the conducting pin (13) in such a manner that it forms an electrical contact with the latter, as claimed in any one of the preceding Claims, characterized in that it comprises the following steps:

a) forming the conductor tracks (22) according to a desired geometry on one upper surface (35) of an insulating substrate (30) provided with holes (33) adapted to receive said elements (1);

b) inserting into the holes (33) at least the supports (10) of the elements (1), the latter comprising an electrically conducting pin (13) having an upper surface (15) and a lower surface (16), an insulating ring (12) surrounding a lateral upper part (19) of the conducting pin (13) and a conducting ring (11) surrounding the insulating ring (12), the desired geometry of the conductor tracks (22) being such that the latter get into electrical contact with the corresponding conducting rings (11);

c) uniting the conducting rings (11) with the corresponding conductor tracks (22) of the upper surface (35) of the substrate (30);

d) forming conductor tracks (24) according to a desired geometry on the lower surface (36) of the substrate (30) in such a manner that the latter gets into electrical contact with the lower surface (36) of the conducting pin (13);

e) uniting the conducting pin (13) with the corresponding conductor tracks (24) of the lower surface (36) of the substrate (30);

f) providing on the substrate at least one wafer (20) having a plurality of parabolic reflecting cavities (21) being prolonged by cylindrical insulating openings (41) engaging the conducting rings (11) with a small amount of clearance until the insulating lower surface of the wafer engages the substrate (30).

11. A method as claimed in Claim 10, characterized in that the conductor tracks (22, 24) of at least one of the surfaces (35, 36) of the substrate (30) are formed by silk screen printing, said uniting step being carried out by sintering the tracks (22, 24) obtained by silk screen printing.

12. A method as claimed in any one of Claim 10 or 11, characterized in that light-emitting components (17) are mounted on the upper surface (15) of the conducting pins (13) before the supports (10) are inserted into the holes (33) of the insulating substrate (30).

13. A method as claimed in any one of Claim 10 or 11, characterized in that light-emitting components (17) are mounted on the upper surface (15) of the conducting pins (18) after any one of the steps a) to f).

14. A method as claimed in any one of Claim 12 or 13, characterized in that it comprises a step of enveloping the light-emitting components (17) by a protective dome (14) of transparent material.

FIG.1a

FIG.1b

FIG.1c

FIG.2

FIG.3a

FIG.3b

FIG.4